# EUROPEAN PATENT APPLICATION

(11) **EP 0 926 599 A1**
(43) Date of publication of application: **30.06.1999**
(21) Application number: 97830718.9
(22) Date of filing: 24.12.1997
(51) Int. Cl.: G06F 12/00, G06F 13/16

(54) **Memory control unit with programmable timing**

(71) Applicant: BULL HN INFORMATION SYSTEMS ITALIA S.p.A., 10014 Caluso (Torino) (IT)
(72) Inventor: Grassi, Antonio, I-22060 Carimate - Como (IT); Grassi, Maurizio, I-20010 Pregnana Milanese - Milano (IT); Zanzottera, Daniele, I-20020 Busto Garolfo - Milano (IT)
(74) Representative: Pezzoli, Ennio

(57) **Abstract**

Control unit (Cm) for a central memory (115) of a computer system capable of generating sequences of commands for the said memory (115), each sequence comprising a plurality of commands separated from each other according to a timing defined by periods of a clock signal, in which the control unit (Cm) includes means (230, 233) for programming the timings of the command sequences in the control unit (Cm) installed in the computer system (100).

## Description

The present invention relates to a control unit for a central memory of a computer system, and in particular to a control unit according to the preamble of the first claim.

Computer systems generally include one or more processors and a central memory, on which the processors operate directly, and which contains the instructions of the programs executed by the computer system, the corresponding data and the intermediate and final results of the processing operations. The central memory is controlled by sequences of commands generated by an appropriate control unit; the commands in each sequence are separated from each other according to a predetermined timing, defined by periods of a clock signal and established according to the specific features of the components used and the characteristics of the computer system.

A disadvantage of known memory control units is that each change of components of the central memory or of parameters of the computer system (for example its operating frequency) requires the provision of a new logic of the memory control unit to adapt the timing of the command sequences to the different characteristics of the computer system. Similar considerations apply in the case in which errors in the timing of the command sequences appear during the use of the computer system; in such a case it is necessary to replace the memory control unit with a new component having a different logic.

The object of the present invention is to overcome the aforesaid disadvantages. In order to achieve this object a control unit as described in the first claim is proposed.

Further characteristics and the advantages of the control unit according to the present invention will be made clear by the following description of a preferred embodiment of the invention, provided for information only and without any restriction being implied, with reference to the attached figures, in which:
Fig. 1 is a block diagram of a computer system in which the control unit according to the present invention can be used;
Fig. 2 shows schematically a simplified structure of the control unit shown in Fig. 1;
Figs. 3a-3b show in timing diagrams an example of a sequence of commands generated by the memory control unit with two different timings;
Figs. 4a-4b show in timing diagrams an example of the operation of the interface unit shown in Fig. 2.

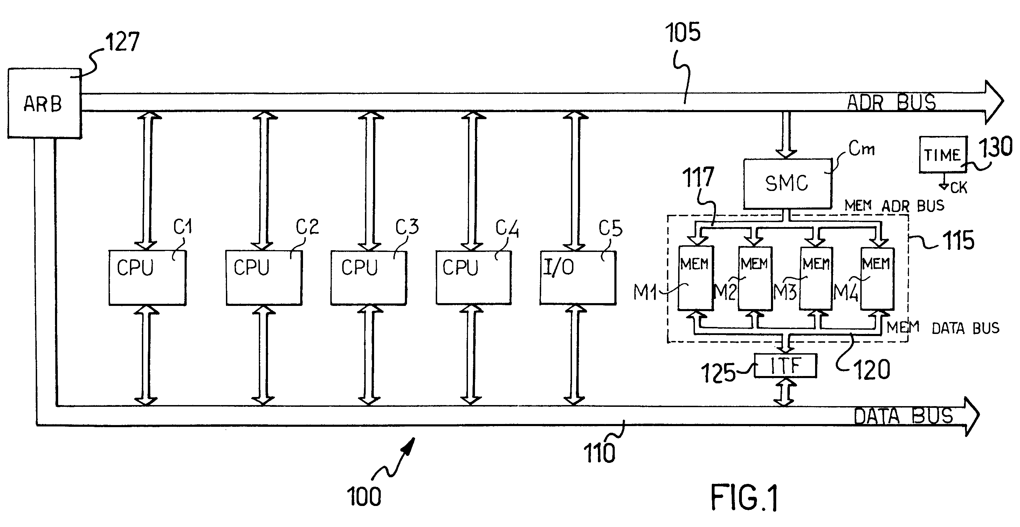

With reference to Fig. 1 in particular, there is shown a computer system 100 comprising an address bus (ADR BUS) 105 and a data bus (DATA BUS) 110, both for example of the type with 64 working bits plus a variable number of bits used for transmitting corresponding control signals. A value (ADR) indicating an address (DAdr) of a data element (of the central memory, of an internal register of a processor, of a remote memory of a cluster of processors, or the like) and the type of operation (DOp) required (reading, writing, reading with the intention of modifying the data element, or the like) is transmitted along the address bus 105; typically, the data are not controlled with an ordered flow and may be supplied to a requesting processor in any sequence (Out of Order), so the ADR value also includes a tag (DTag) which identifies the requesting processor and the transaction relating to it. A data element generally consists of a cache memory line of 512 bits (64 bytes), and therefore it is transmitted along the data bus 110 with the operation serialized into a plurality of successive stages (8 in the example in question), during each of which a 64-bit block and the associated identifying tag are transmitted.

One or more processors C1, C2, C3, C4 and C5 (five in the example illustrated), each being typically provided with an internal memory of the cache type, are connected in parallel to the address bus 105 and to the data bus 110; the processors C1-C5 consist of central processing units (CPU) , or alternatively input/output (I/O) control units, interface (bridge) units for connection to a group (cluster) of processors, or the like.

The computer system 100 includes a shared central memory 115, typically of the dynamic random access type (DRAM). Each addressable entry of the central memory 115 contains a word which is processed simultaneously and consists, for example, of 256 bits (32 bytes); the reading/writing of a data element, consisting of a 64-byte cache memory line in the example in question, therefore requires the sequential reading/writing of two consecutive locations of the central memory 115. Preferably, the central memory 115 consists of a plurality of banks (MEM) M1, M2, M3 and M4 (four in the example illustrated) controlled in interleaving mode, having a common input and output for the data, each of the banks being associated with a corresponding address staticizing register (not shown in the figure).

The central memory 115 is connected to the address bus 105 through a memory control unit (System Memory Control, or SMC) Cm; the connection between the control unit Cm and the central memory 115 is through a memory address bus (MEM ADR BUS) 117 (of the 14-bit type, for example). A memory data bus (MEM DATA BUS) 120 connects the central memory 115 to an interface unit (ITF) 125; the memory data bus 120 has, for example, a capacity of 128 bits (16 bytes), and therefore the transmission of a 32-byte word is serialized into two successive stages. The interface unit 125 is connected to the system data bus 110 and typically carries out the function of staticizing the data (for their subsequent transmission along the system data bus 110), of error recognition (and possibly correction), and so on.

The agents C1-C6, Cm and C1-C5, 125 are connected simultaneously to the address bus 105 and to the data bus 110 respectively, to receive the values transmitted on them; access with reciprocal exclusion to the address bus 105 and to the data bus 110 by the corresponding agents for sending a given value is controlled by an appropriate arbitration unit (ARB) 127.

A timer unit (TIME) 130 generates a clock signal Ck which is supplied to the processors C1-C5, to the control unit Cm, to the central memory 115, to the interface unit 125 and to the arbitration unit 130 to synchronize the operation of the computer system 100.

The control unit according to the present invention is, however, also suitable for use in other computer systems, for example those having a different number of processors (at the limit, only one, in a single-processor system), or a central memory consisting of a different number of banks (at the limit, only one, in a central memory not controlled in interleaving mode), or a data bus with fully synchronous operation, or an arbitration unit provided within the memory control unit, and so on.

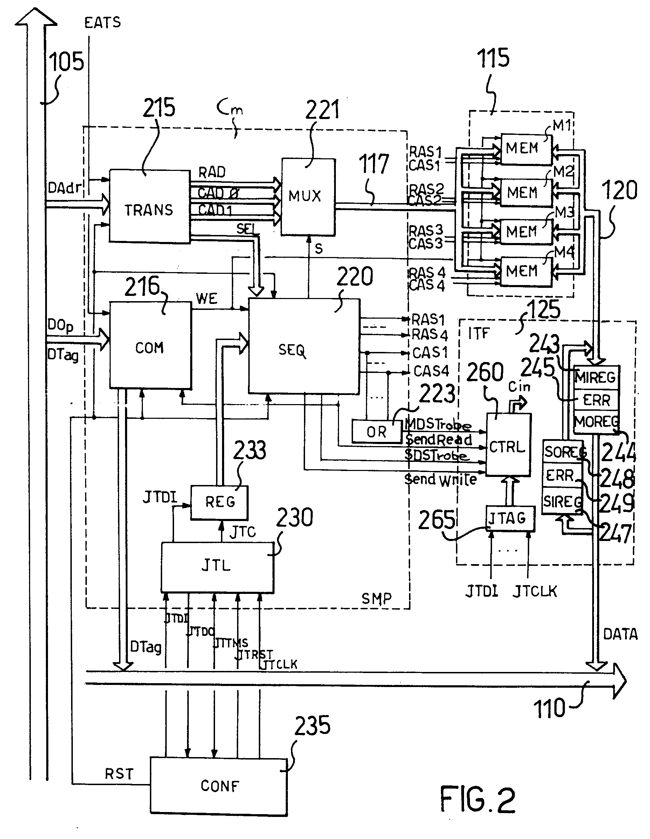

With reference now to Fig. 2 (elements already shown in Fig. 1 are indicated by the same reference numbers or symbols), the memory control unit Cm includes a translation logic (TRANS) 215 and a command logic (COM) 216 which receive from the address bus 105, respectively, the portion of the value ADR containing the address DAdr of the data element (to be read or written) and the portion of the value ADR containing the type of operation DOp and the identifying tag DTag relating to the data element. The reception of the transmitted value is controlled by a signal indicating the validity of the value which is present in the address bus 105 (Early Transfer Start, or EATS) and is generated by the arbitration unit. The translation logic 215 converts the received address DAdr into a value SEL indicating the memory bank M1-M4 to be selected and into a memory address suitable for identifying the data element in the selected memory bank M1-M4. In particular, each memory location can be addressed by means of a row address (consisting of 12 bits for example) and a column address (consisting of 10 bits for example); in the example in question, in which each data element consists of two consecutive words, the address DAdr is translated into a common row address RAD and into two consecutive column addresses CAD0 and CAD1. The command logic 216 stores the identifying tag DTag and generates a signal WE indicating the type of operation (reading or writing) to be executed at the addressed location, which is sent along a dedicated line to the memory banks M1-M4.

The signal WE, the selection value SEL and the signal EATS are applied to the input of a command sequencing logic (SEQ) 220; the sequencing logic 220 essentially consists of a number of finite state machines equal to the number of memory banks M1-M4; it changes with each clock signal as a function of the previously received signals and is capable of keeping track of the state of the central memory 115. The row address RAD and the column addresses CAD0, CAD1 are applied to separate groups of inputs of a multiplier circuit, or multiplexer (MUX) 221. The multiplexer 221 transfers to one of its own outputs, connected to the memory address bus 117, the value present at only one of these groups of inputs, according to a selection signal S supplied by the sequencing logic 220; in this way, the row address RAD and the column addresses CAD0 and CAD1 are sent in sequence to the memory banks M1-M4.

The sequencing logic 220 is connected to each memory module M1-M4 through a dedicated line for sending a row address validation signal (Row Address Strobe) RASⱼ (where j=M1-M4), and through a further dedicated line for sending a column address validation signal (Column Address Strobe) CASⱼ; the RASⱼ and CASⱼ signals enable each memory module M1-M4 to receive from the memory address bus 117 the row address RAD and column address CAD0, CAD1 respectively transmitted on this bus, while also intrinsically executing the function of selection of the memory bank M1-M4.

The signals CASⱼ are also applied to a logic (OR) 223 which essentially executes a logical OR operation between the CASⱼ signals and generates, with a predetermined and programmable delay (as described later), a signal MDStrobe which indicates the validity of the value present in the memory data bus 120, and which is supplied to the interface 125 to enable the reception of the words read from the central memory 115. A dedicated line is used by the sequencing logic 220 for sending to the interface unit 125 and to the command logic 216 a signal SendRead which enables the transmission along the system data bus 110 of the data element read from the central memory 115 (DATA) and of the associated identifying tag (DTag) respectively. In this way, after the memory control unit Cm has obtained access to the system data bus 110, the data element that has been read (stored in the interface unit 125) and the associated identifying tag (stored in the command logic 216) are sent simultaneously along the system data bus 110.

The interface unit 125 also receives from the sequencing logic 220 a signal SDStrobe enabling reception of the data element transmitted along the system data bus 110, so that it can subsequently be sent to the central memory 115 through the memory data bus 120 during a write operation. A dedicated line is used by the sequencing logic 220 to send to the interface unit 125 a signal SendWrite enabling the data element (received from the system data bus 110) to be sent along the memory data bus 120 so that it can be written to the central memory 115.

Further signals are exchanged between the sequencing logic 220 and the arbitration unit on dedicated lines (not shown in the figure) to control the request and the granting of access to the data bus 110 and the occupation of this bus (for the command logic 216 and the interface unit 125). The sequencing logic 220 is also connected to the arbitration unit through dedicated channels (not shown in the figure) to control a snooping process, used to ensure the consistency of the data of the central memory 115 replicated in the cache memories of the processors.

The present invention, however, can also be applied with equivalent control units which use other types of signals, different connections to the other units of the computer system, and so forth.

The memory control unit Cm also includes a serial test interface, preferably of the standardized type known as a "Joint Test Access Group" (JTAG). This serial test interface is commonly used for testing the memory control unit Cm and for the periodic checking of its functionality. It can also be used to define an initial configuration (default) of the memory control unit Cm (for example a range of addresses recognized as valid) and to modify its logical operation. For example, it is possible to change the procedure for translating the received addresses, or to increase the number of column validation signals CASⱼ generated during the operation of reading a data element for reading more words, in such a way as to adapt the operation of the memory control unit Cm to processors which require data of greater length, and so on. It should be noted, however, that the serial test interface is used in known devices exclusively for modifying the logical operation of the memory control unit Cm, and not the timings of the command sequences.

The serial test interface includes a JTAG control logic (JTL) 230 (essentially consisting of a finite state machine) which controls, by means of suitable control signals JTC, the transfer of the input data to one or more shift registers (REG) 233. The JTAG control logic 230 is connected to an external configuration unit (CONF) 235; typically, the external configuration unit 235 is controlled by a program (software) or a micro-program (firmware) and can be used to specify initial configuration data for the computer system, by loading them, for example, from a magnetic storage medium such as a diskette.

In particular, the JTAG control logic 230 is connected to the external configuration unit 235 through a dedicated line for receiving an input serial data signal JTDI and through a further dedicated line for sending an output serial data signal JTDO. Further dedicated lines are used to send from the external configuration unit 235 to the JTAG control logic 230 a signal JTTMS for selecting the test mode and an initialization (reset) signal JTRST, which sets both the state machine of the JTAG control logic 230 and the shift register 233 to an initial state. The external configuration unit 235 is also connected to the JTAG control logic 230 through a dedicated line for sending a clock signal JTCLK (separate from the general clock signal of the system) which is used to time the operation of the serial test interface.

When the JTAG control unit 230 is activated by the selection signal JTMMS, the input serial data element JTDI is recognized (strobed) with each rising edge of the clock signal JTCLK and an output serial data element JTDO is sent along the corresponding dedicated line with each falling edge of the clock signal JTCLK. With a succession (burst) of pulses of the clock signal JTCLK it is therefore possible to send to the memory control unit Cm a series (string) of binary data which are loaded serially into the shift register 233.

The configuration unit 235 is also connected to the logics 215, 216 and 220 for sending a system initialization signal RST (which is distinct from the initialization signal JTRST). At the end of the stage of loading the shift register 233, the system initialization signal RST sets the various logics 215, 216 and 220 of the memory control unit Cm to an initial condition.

The shift register 233 has an output of the parallel type which is connected to the input of the sequencing logic 220; the contents of the shift register 233 define the timings of the command sequences generated by the sequencing logic 220.

The control unit according to the present invention can be used to modify the timings of the command sequences in a simple and rapid way; it is thus possible to change the components of the central memory or the parameters of the computer system without the necessity of replacing the memory control unit. The solution according to the present invention is particularly useful at the design stage of the computer system, since it makes it possible to easily check limit operating conditions. The control unit according to the present invention simplifies the recognition of errors (debugging), enabling the computer system to be checked in successive stages in which a single operating parameter is varied each time. Furthermore, with this structure it is possible to update the control unit (to correct any errors or to adapt its operation to new characteristics of the computer system) directly in a computer system which has already been installed at a customer's premises, by simple maintenance operations.

The timings of the command sequences are generated by the sequencing logic by continuously reading the contents of the shift register described above; this does not cause any slowing of the operation of the memory control unit, since this reading operation is executed in the same clock period as that used to generate the command. In any case, any slowing of the operation of the memory control unit is amply compensated for by the advantages described above.

The use of the serial test interface of the JTAG type is particularly advantageous in that it makes it possible to program the timings of the command sequences generated by the memory control unit with the use of preexisting functions. Alternatively, a different test interface (possibly not of the serial type) is used, the memory control unit Cm is provided with control terminals which enable the timing programming data to be received on other terminals, some terminals of the memory control unit have a double function which may be logical or programming according to the state of other control terminals, and in general equivalent means are provided to program the timings of the command sequences generated by the memory control unit with the memory control unit installed in the computer system.

In a preferred embodiment of the present invention, the interface unit 125 is also programmable in a similar way. In particular, the interface unit 125 includes an input register (MIREG) 243 connected to the memory data bus 120 to receive and staticize (in response to the enabling signal MDStrobe sent by the memory control unit Cm) the data read from the central memory 115, and an output register (MOREG) 244 to staticize the read data and then send them in succession to the system data bus 110 (in response to the SendRead enabling signal sent by the memory control unit Cm). The input register 243 and the output register 244 are connected together in series by an error checking and correction logic (ERR) 245; during an operation of reading from the central memory 115, the error logic 245 receives the data from the input register 243, checks and if necessary corrects these data (if possible), and then sends the data to the output register 244. The interface unit 125 also includes an input register (SIREG) 247 connected to the system data bus 110 to receive and staticize (in response to the enabling signal SDStrobe sent by the memory control unit Cm) the data to be written to the central memory 115, and an output register (SOREG) 248 to staticize these data and then send them in succession to the memory data bus 120 (in response to the enabling signal SendWrite sent by the memory control unit Cm). The input register 247 and the output register 244 are connected together in series by a further error checking and correction logic (ERR) 249.

A control logic (CTRL) 260 receives at its input the various signals (MDStrobe, SendRead, SDStrobe, SendWrite) sent by the memory control unit Cm and, by means of suitable sequences of internal command signals (indicated cumulatively by Cin), controls the operation of the input registers 243 and 247, of the output registers 244 and 248, and of the error logics 245 and 249. A serial test interface of the JTAG type 265 similar to that described previously (or other equivalent means) is connected to the control logic 260 to program the timings of these sequences of internal command signals Cin. The present invention is, however, also suitable for application with an interface unit having non-programmable timing, and possibly with one not having any internal logic.

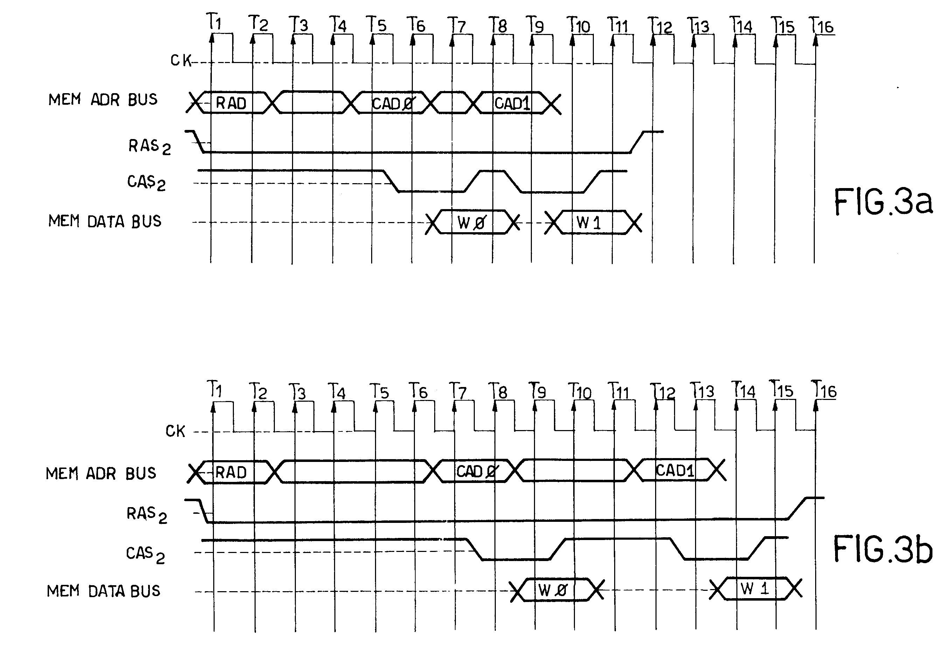

In order to describe an example of programming of the memory control unit according to the present invention, reference will be made to Fig. 3a, which shows, in a timing diagram, a sequence of commands generated by the memory control unit for reading a data element from the central memory. As usual, the various signals are set/reset, in other words they are switched to a low/high value (or vice versa), at the rising edge of the clock signal Ck; at a subsequent rising edge (after one or more periods of the clock signal Ck) the state of the signals is stable and can be recognized (strobed); a signal (one bit) is represented by a single line, while values comprising a plurality of bits are represented by a band (the points of intersection are the instants of switching).

Let it be assumed that at the instant T1 the memory control unit initiates the reading of a data element from the central memory by activating a corresponding memory bank, for example the bank indicated by M2 in Fig. 1. In particular, the memory control unit sends the row address RAD along the memory address bus (MEM ADR BUS) (instants T1-T2); the signal WE (not shown in the figure) is kept reset to indicate that the operation to be executed at the addressed location is a reading operation. At the instant T1, the corresponding row address validation signal RAS₂ is set. The first column address CAD0 is sent along the memory address bus, for example at the instants T5-T6, and at the instant T6 the corresponding column address validation signal CAS₂ is set, in such a way that the first word of the requested data element (W0) is read from the memory bank M2 at the instants T7-T8 and simultaneously transferred along the memory data bus (MEM DATA BUS) to be received by the interface unit. At the instant T8 the signal CAS₂ is reset; simultaneously, the second column address CAD1 is sent along the memory address bus (instants T8-T9) and at the successive instant T9 the signal CAS₂ is set again, in such a way that the second word of the requested data element (W1) is read from the memory bank M2 at the instants T10-T11 (and simultaneously transferred along the memory data bus). The signals CAS₂ and RAS₂ are then reset, at the instant T11 and at the instant T12 respectively, terminating the access to the memory bank M2.

It will now be assumed that the frequency of the clock signal of the computer system is modified, for example from 75 MHz (and therefore a period of 13.3 ns) to 100 MHz (and therefore a period of 10 ns). To ensure the correct operation of the central memory, it is necessary to keep the duration of the operation of access to this memory substantially unchanged. For this purpose it is sufficient to modify the timing of the sequence of commands generated by the memory control unit as illustrated in Fig. 3b. In this way, the operation of accessing the central memory has a duration of 16 clock periods (equal to 16·10=160 ns) which is substantially unchanged from that in the preceding case (12·13.3=159.6 ns).

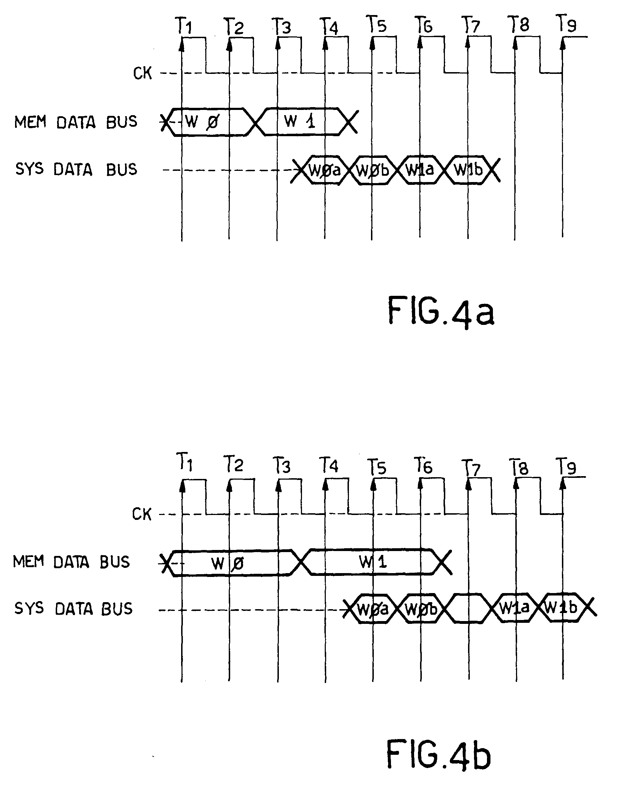

With reference now to Fig. 4a, a timing diagram shows an example of an operation of data transfer from the central memory to the system data bus. Assume that at the instant T1 the central memory sends a word (W0) along the memory data bus (MEM DATA BUS) to transfer the word to the interface unit. The transfer of a word along the memory data bus requires 2 clock periods, and therefore the word W0 is received by the interface unit at the instant T2. Similarly, the central memory sends a further word (W1) along the memory data bus at the instant T3, and this word is received by the interface unit at the instant T4. The interface unit sends the first received word along the system data bus (SYS DATA BUS) at the instant T4; in the example in question in which the memory data bus has a capacity of 128 bits and the system data bus has a capacity of 64 bits, the transmission of the word along the system data bus is serialized into two successive stages (instants T4 and T5) in each of which a half-word (W0a and W0b respectively) is sent. Similarly, at the instants T6 and T7 the interface unit sends half-words W1a and W1b respectively, corresponding to the second word received, along the system data bus.

It will now be assumed that the number of memory banks installed and therefore connected to the memory data bus increases (from 2 to 8, for example). In this case, the higher capacitive load connected to the memory data bus increases its propagation time, so that the transfer of a word requires, for example, 3 clock periods. To ensure the correct operation of the interface unit, it is sufficient to modify the timing of the sequence of internal commands generated by this unit, as illustrated in Fig. 4b. In this way, the half-words W0a and W0b corresponding to the first word received from the central memory are sent along the system data bus at the instants T5 and T6 respectively; similarly, at the instants T8 and T9 the interface unit sends the half-words W1a and W1b respectively, corresponding to the second word received, along the system data bus.

Clearly, those skilled in the art may make numerous modifications and changes to the memory control unit described above, which would nonetheless all be included within the scope of protection of the invention as defined by the following claims.

## Claims

1. Control unit (Cm) for a central memory (115) of a computer system (100) capable of generating sequences of commands for the said memory (115), each sequence comprising a plurality of commands separated from each other according to a timing defined by periods of a clock signal (Ck),
characterized in that
it includes means (230, 233) for programming the timings of the command sequences in the control unit (Cm) installed in the computer system (100).

2. Control unit (Cm) according to Claim 1, in which the programming means include a serial test interface (230, 233).

3. Control unit (Cm) according to Claim 2, in which the serial test interface (230, 233) is of the JTAG type.

4. Control unit (Cm) according to Claim 3, in which the serial test interface (230, 233) includes a control logic (230) for serially receiving binary programming data (JTDI) and for loading the said binary programming data (JTDI) into storage means (233), the timings of the command sequences being defined as a function of the contents of the storage means (233).

5. Control unit (Cm) according to Claim 4, in which the storage means include at least one shift register (233) having a serial input and an output of the parallel type.

6. Computer system (100) comprising a central memory (115) and the control unit (Cm) for the said central memory (115) according to any of Claims 1 to 5.

7. Computer system (100) according to Claim 6, further comprising an interface unit (125) for connecting the central memory (115) to a system data bus (110), in which the interface unit (125) is provided with a control logic (260) for generating sequences of internal commands in the interface unit (125), each sequence comprising a plurality of internal commands separated from each other according to a timing defined by periods of the clock signal (Ck), and with further means (265) for programming the timings of the sequences of internal commands in the interface unit (125) installed in the computer system (100).

8. Computer system (100) according to Claim 7, in which the further programming means include a further serial test interface (265).

9. Computer system (100) according to Claim 8, in which the furhter serial test interface (265) is of the JTAG type.

10. Method for controlling a central memory (115) of a computer system (100), comprising the following steps:
defining command sequences for the said memory (115), each sequence comprising a plurality of commands separated from each other according to a timing defined by periods of a clock signal (Ck),
programming the timings of the command sequences in the control unit (Cm) installed in the computer system (100), and
sending the command sequences to the memory (115).
